# EUROPÄISCHE PATENTSCHRIFT

(11) **EP 1 842 406 B1**
(45) Veröffentlichungstag und Bekanntmachung des Hinweises auf die Patenterteilung: **02.05.2018**
(21) Anmeldenummer: 06703917.2
(22) Anmeldetag: 24.01.2006
(51) Int. Cl.: H05K 3/20

(54) **VERFAHREN ZUR DURCHGEHENDEN VERLEGUNG EINES LEITUNGSDRAHTES AUF EINER LEITERPLATTE UND VORRICHTUNG ZUR DURCHFÜHRUNG DES VERFAHRENS**
METHOD FOR THE CONTINUOUS LAYING OF A CONDUCTOR ON A PRINTED CIRCUIT BOARD AND DEVICE FOR CARRYING OUT SAID METHOD
PROCEDE POUR POSER, SANS INTERRUPTION, UN FIL CONDUCTEUR SUR UNE CARTE DE CIRCUITS IMPRIMES ET DISPOSITIF POUR LA MISE EN OEUVRE DUDIT PROCEDE

(30) Priorität: 24.01.2005 DE 102005003370
(43) Veröffentlichungstag der Anmeldung: 10.10.2007
(73) Patentinhaber: JUMATECH GmbH, 90542 Eckental (DE)
(72) Erfinder: WÖLFEL, Markus, 90542 Eckental (DE)
(74) Vertreter: Grünecker Patent- und Rechtsanwälte PartG mbB
(86) Internationale Anmeldenummer: PCT/EP2006/000616
(87) Internationale Veröffentlichungsnummer: WO 2006/077167

(56) Entgegenhaltungen:
- DE-A1- 3 126 109
- DE-A1- 10 216 526
- DE-A1- 10 317 879
- US-A- 5 097 100
- US-A- 5 110 032
- US-A1- 2002 179 234
- US-A1- 2004 074 086

## Beschreibung

Die Erfindung betrifft ein Verfahren zum Verschweißen eines Leitungsdrahts mit einer leitfähigen Folie, welche vorzugsweise zur Verbindung mit einem Leiterplattenträger zur Herstellung einer Leiterplatte bestimmt ist, wobei die Dicke oder der Durchmesser des Leitungsdrahtes vorzugsweise größer ist, als die Dicke der leitfähigen Folie gemäß dem Oberbegriff des Anspruchs 1 sowie eine Vorrichtung zur Ausführung dieses Verfahrens.

Üblicherweise werden Signale und Ströme auf Leiterplatten für elektrische und elektronische Schaltungen durch Leiterbahnen übertragen, die durch ein Ätzverfahren hergestellt werden, d.h. von einer auf einer Trägerplatte aufgebrachten Kupferfolie werden die zwischen den gewünschten Leiterbahnen liegenden Bereiche abgeätzt und damit elektrisch voneinander getrennt und nur an den gewünschten Stellen die Kupferfolie erhalten. Da die Dicke der Kupferfolie und der Querschnitt der durch dieses Verfahren erzeugbaren Leiterbahnen unter anderem durch die Bestückungs- und Verdrahfiungsdichte und aufgrund der technischen Möglichkeiten des Ätzverfahrens beschränkt ist, ist hierbei die Übertragung höherer Ströme, aber auch das Verrouten insbesondere bei einlagigen oder zweilagigen Platinen insbesondere bei Vorgabe anspruchsvoller, technischer Spezifikationen nach diesem Verfahren oft unzulänglich oder nicht möglich.

Die DE 101 08 168 C1 beschreibt ein Verfahren zur Herstellung einer Multiwire-Leiterplatte unter Anwendung eines Drahtschreibeverfahrens, wobei auf der Innenseite eines dünnen Flächenelements aus elektrisch leitendem Material der Drahtverschreibung entsprechende Leitungsdrähte definiert verlegt und an definierten Kontaktstellen des Flächenelements kontaktiert und festgelegt werden. Anschließend wird auf der Innenseite des Flächenelements mit den kontaktierten Leitungsdrähten ein Stabilisierungsflächenelement festgelegt. Danach wird das dünne Flächenelement von seiner Außenseite her derartig strukturiert, dass die Kontaktstellen vom übrigen Flächenelement getrennt und somit elektrisch voneinander isoliert werden. Derartige Leiterplatten geringer Dicke können zu einer kompakten Mehrlagenschaltung zusammengebaut werden.
Durch das in der DE 101 08 168 C1 beschriebene Verfahren können eine Reihe von Nachteilen konventioneller Leiterplatten vermieden werden. Jedoch war nach dem in der DE 101 08 168 C1 beschriebenen Verfahren die Verschweißbarkeit beispielsweise dicker Drähte auf dünnen Kupferfolien bislang begrenzt. Deshalb war es ein Anliegen, das Spektrum an verschweißbaren Leitungsdrähten auf dünne, leitfähige Folien sowie die dabei zu erzielende Verschweißungsqualität und Verschweißungssicherheit insbesondere bei der Verschweißung dicker Leitungsdrähte auf dünnen, leitfähigen Folien weiter zu verbessern und den effektiven Leiterquerschnittsverlaufs im Bereich um die Schweißstelle und ohne Beeinträchtigung der leitfähigen Folie in der Verschweißungsregion weitgehend zu erhalten.

US 5 097 100 A betrifft eine korrosionsbeständige Verbindung eines Drahts mit einem Substrat.

US 5 110 032 A betrifft ein Drahtbondverfahren zum Verbinden eines Drahts mit einem Halbleiter-Chip. Der vorliegenden Erfindung liegt daher die Aufgabe zugrunde, ein Verfahren zum Verschweißen eines Leitungsdrahts mit einer leitfähigen Folie anzugeben, welche vorzugsweise zur Verbindung mit einem Leiterplattenträger zur Herstellung einer Leiterplatte bestimmt ist, wobei die Dicke oder der Durchmesser des Leitungsdrahtes vorzugsweise größer ist, als die Dicke der leitfähigen Folie, und welches einfach und kostengünstig zu realisieren ist, industriell in Drahtschreibeautomaten einsetzbar ist und die bislang bekannten Verfahren insbesondere in vorbeschriebener Weise deutlich verbessert.
Diese Aufgabe wird erfindungsgemäß gelöst durch ein Verfahren zum Verschweißen eines Leitungsdrahtes mit einer leitfähigen Folie nach dem Oberbegriff des Anspruchs 1, wobei die leitfähige Folie sich - zumindest während des Verschweißens - mit einer thermischen Trennplatte in Kontakt befindet, deren Wärmeleitfähigkeit geringer ist, als die der leitfähigen Folie.
Gemäß dem Vorrichtungsaspekt der vorliegenden Erfindung wird die Aufgabe nach Anspruch 25 durch eine Vorrichtung zur Ausführung des erfindungsgemäßen Verfahrens gelöst, welche wenigstens folgende, durch ein elektronisches Steuergerät numerisch gesteuerte Einrichtungen beinhaltet:
a) eine Einrichtung (8, 10, 14) zur Erzeugung einer Relativbewegung zwischen einer leitfähigen Folie (4) und einem Leitungsdrahtspeicher (16),
b) b) eine Einrichtung (24) zum stoffschlüssigen Verbinden von Leitungsdraht (2) mit elektrischen Anschlussstellen (36, 40) auf der leitfähigen Folie (4).
c) eine thermische Trennplatte zur Auflage der Folie, wobei die Wärmeleitfähigkeit der thermischen Trennplatte geringer ist als das Kupfer der leitfähigen Folie
d) sowie eine durch das Steuergerät (32) ansteuerbare Klebeeinrichtung (26) zum Verkleben des Leitungsdrahts (2) mit der leitfähigen Folie (4) an Stellen, an welchen der Leitungsdraht (2) eine Richtungsänderung erfährt.

Durch das erfindungsgemäße Verfahren ist es in vorteilhafter Weise möglich, ein großes Spektrum an Leitungsdrähten mit den im elektronischen Bereich üblicherweise Anwendung findenden Kupferfolien mit typischen Stärken zwischen 18 µm und 70 µm zu verschweißen und die Leitungsdrähte geschützt im Inneren der Leiterplatte eingebettet zu führen. Dabei können insbesondere Leitungsdrähte mit rundem oder rechteckigem Querschnitt zum Einsatz kommen, deren Durchmesser oder Dicke beispielsweise um den Faktor 2 bis 10 größer ist, als die Dicke der leitfähigen Folie. Weiterhin ist das erfindungsgemäße Verfahren auch bei Kupferfolien mit mehreren hundert µm Stärke vorteilhaft einzusetzen. Ein weiterer Vorteil ist die hohe Sicherheit und Qualität der Verschweißung, die durch das erfindungsgemäße Verfahren erzielt werden kann. Weiterhin kann mit dem erfindungsgemäßen Verfahren der effektive, für den Stromfluss zur Verfügung stehende Querschnittsverlauf im Bereich der Schweißstelle weitgehend aufrecht erhalten und so die Ausbildung von sogenannten "Hotspots" vermieden werden. Außerdem ist im Bezug auf ungünstige Umgebungsbedingungen eine sehr gute mechanisch und chemisch resistente Verschweißung erzielbar. Durch das große Spektrum an verschweißbaren Leitungsdrähten und die große Freiheit bei der Auswahl der leitfähigen Folie lassen sich durch das erfindungsgemäße Verfahren neue Einsatzbereiche insbesondere im Leistungs- und Hochstrombereich, aber auch in der Kombination von Leistungselektronik, u.a. mit Präzisionselektronik, hochintegrierter Elektronik und/oder hohen Bestückungsdichten erschließen. Ein weiterer Vorteil ist die hohe Verschweißungsgeschwindigkeit und die sehr gute industrielle Anwendbarkeit beispielsweise mit numerisch gesteuerten Drahtschreibeautomaten.

In einer bevorzugten Ausführungsform kann die Wärmeleitfähigkeit der thermischen Trennplatte - zumindest in einer um den Verschweißungsbereich gelegenen Region - mindestens um den Faktor 2, vorzugsweise mindestens um den Faktor 5 geringer sein, als die der leitfähigen Folie. Hierdurch kann eine besonders gute Verschweißungsqualität erreicht werden, durch die kontrollierte Abführung der beim Schweißen entstehenden Wärme.

In einer weiteren bevorzugten Ausführungsform kann die thermische Trennplatte eine höhere Schmelztemperatur und eine höhere thermische Beständigkeit aufweisen, als die der leitfähigen Folie und/oder die Temperaturbelastung während des Schweißvorgangs, wodurch eine Erweichung der Trennplatte, Verbindung der Trennplatte mit der leitfähigen Folie und/oder ungünstige physikalisch-chemische Interaktion zwischen der thermischen Trennplatte und der leitfähigen Folie während des Verschweißens vermieden wird.

In einer weiteren bevorzugten Ausführungsform kann die thermische Trennplatte zumindest in einem um den Verschweißungsbereich gelegenen Kontaktbereich zur leitfähigen Folie, vorzugsweise im gesamten Auflagebereich der leitfähigen Folie, eine Beschichtung mit höherer thermischer Beständigkeit und/oder geringerer thermischer Leitfähigkeit aufweisen als das Grundmaterial. Durch das Aufbringen einer solchen Beschichtung können die Eigenschaften der thermischen Trennplatte weiter verbessert werden und der Körper der Trennplatte kann aus einem anderen Material gefertigt werden als die Beschichtung, wodurch die Eigenschaften von Körper und Beschichtung in einem höheren Maße optimiert und noch besser an die Prozessführung während des Verschweißens angepasst werden können.

Nach einer weiteren bevorzugten Ausführungsform kann die thermische Trennplatte zumindest in einem um den Verschweißungsbereich gelegenen Kontaktbereich zur leitfähigen Folie vorzugsweise im gesamten Auflagebereich der leitfähigen Folie eine Inertoberfläche, vorzugsweise in Form einer Inertbeschichtung, aufweisen. Durch eine solche Inertoberfläche oder Inertbeschichtung kann einerseits eine oberflächliche Veränderung der thermischen Trennplatte im Kontakt mit der leitfähigen Folie und/oder der Umgebungsluft und/oder anderen anwesenden Stoffen während der Erhitzung durch den Schweißvorgang vermieden werden und andererseits eine physikalische, physikochemische und/oder chemische Verbindung zwischen leitfähiger Folie und thermischer Trennplatte unterbunden werden.

In einer weiteren bevorzugten Ausführungsform kann die thermische Trennplatte elektrisch leitfähig, vorzugsweise hochleitfähig sein, wodurch die thermische Trennplatte zur Durchleitung und/oder Fortleitung des Schweißstroms genutzt werden kann, und sich das Schweißergebnis verbessern lässt.

In einer weiteren bevorzugten Ausführungsform kann die Dicke der thermischen Trennplatte vorzugsweise um mindestens den Faktor 5 und höchstens den Faktor 300 größer sein, als die der leitfähigen Folie. Hierdurch ergeben sich günstige Verhältnisse bezüglich der thermischen Isolation und der Stromfortleitung.

In einer weiteren bevorzugten Ausführungsform kann die thermische Trennplatte zwischen der leitfähigen Folie und einer Stromverteilungsvorrichtung vorzugsweise aus einem Kupferblock angeordnet sein. Durch eine solche Sandwichanordnung der thermischen Trennplatte, bei der auf der der leitfähigen Folie gegenüberliegenden Seite der thermischen Trennplatte ein Kupferblock mit einer größeren Dicke (beispielsweise zehnmal so dick wie die thermische Trennplatte) angeordnet ist, kann eine gleichmäßige Verteilung und Abfuhr des Schweißstroms gewährleistet werden.

In einer weiteren bevorzugten Ausführungsform kann die Dicke oder der Durchmesser des zu verschweißenden Leitungsdrahts vorzugsweise um den Faktor 2 bis 10 größer sein, als die Dicke der leitfähigen Folie. Durch den Einsatz solcher dicken Leitungsdrähte ist die Fertigung von Hochstromplatinen mit konventionellen dünnen Stärken der leitfähigen Folie von beispielsweise 18-70 µm Stärke möglich.

In einer weiteren bevorzugten Ausführungsform kann an der Verschweißstelle eine weitere, von Draht und/oder Platine verschiedene metallische Komponente eingebracht werden. Durch das Einbringen einer solchen Komponente kommt es durch Diffusionsprozesse während des Verschweißungsvorgangs zur Ausbildung einer homogenen eutektischen Phase in einem Mikrolegierungsbereich, wodurch Verbindungstemperatur und Verbindungsfestigkeit in günstiger Weise beeinflusst werden.

In einer weiteren bevorzugten Ausführungsform kann der Draht mindestens eine weitere von Draht und/oder Platte verschiedene metallische Komponente, vorzugsweise in Form eines metallischen Überzugs, insbesondere aus Silber oder Zinn, aufweisen. Auf diese Weise ist es möglich, die Vorteile der vorangegangenen Ausführungsform in einer technisch besonders einfachen und sinnvollen Variante zugänglich zu machen.

In einer weiteren bevorzugten Ausführungsform kann die Verschweißung durch ein Kontaktschweißverfahren vorgenommen werden, wobei hierdurch eine besonders exakte Überwachung und Steuerung der Schweißparameter und lokal konzentrierte Erhitzung und ein besonders hochwertiges Schweißergebnis gewährleistet werden kann.

In einer weiteren bevorzugten Ausführungsform kann die Gegenelektrode im Bezug auf die Ebene der Platte der Schweißelektrode gegenüberliegend angeordnet sein. Durch ein solches Durchgangsschweißverfahren können höhere Schweißströme zur Anwendung kommen, was vorteilhaft für die Verschweißung besonders dicker Leitungsdrähte auf dickeren leitfähigen Folien sein kann.

In einer weiteren bevorzugten Ausführungsform können zwei schweißstromführende Elektroden im Bezug auf die Ebene der Kontaktfläche zwischen leitfähiger Folie und thermischer Trennplatte auf derselben Seite angeordnet sein. Auf diese Weise kann Schweißstromzufuhr und Schweißstromabfuhr von derselben Seite, nämlich der Bearbeitungsseite der leitfähigen Folie und unabhängig von den Leitfähigkeitsverhältnissen der thermischen Trennplatte erfolgen.

In einer weiteren bevorzugten Ausführungsform können zwei Schweißelektroden im Bezug auf den Leitungsdraht positionierbar sein, wodurch sich eine stärkere Fokussierung des Schweißstroms auf den Ort der Verschweißung vornehmen lässt.

In einer weiteren bevorzugten Ausführungsform kann die Gegenelektrode als Flächenelektrode ausgebildet und im Bezug auf die Ebene der Platte der Schweißelektrode auf derselben Seite angeordnet sein. Hierdurch ist es z.B. möglich, die Verschweißung auch dicker Leitungsdrähte bei Einsatz einer elektrisch nicht leitfähigen oder schlecht leitfähigen thermischen Trennplatte durchzuführen.

In einer weiteren bevorzugten Ausführungsform kann ein Abisolieren eines isolierten Leitungsdrahts durch thermisches Abschmelzen und/oder durch mechanisches Abtragen oder Abziehen oder Abquetschen, vorzugsweise durch thermisches Abschmelzen mittels eines Lasers oder Abbrennen mittels der Schweißelektroden vorgenommen werden. Hierdurch ist es möglich, isolierte Leitungsdrähte für die Drahtverschreibung einzusetzen, die zuverlässig an unerwünschten Stellen einen elektrischen Kontakt mit der leitfähigen Folie oder anderen Leitungsdrähten in Kreuzungsbereichen vermeiden und/oder höhere Isolationswerte erzielen. Durch das in dieser Ausführungsform beschriebene Verfahren lassen sich derartige Drähte kostengünstig und effizient mittels Drahtschreibungsautomaten mit dem erfindungsgemäßen Verfahren verlegen und mit der leitfähigen Folie kontaktieren.

In einer weiteren bevorzugten Ausführungsform kann das Abschmelzen der Isolierung durch ein zum Leitungsdraht positionierbares Elektrodenpaar, vorzugsweise unter Steuerung und Überwachung von Prozessparametern vorgenommen werden. Auf diese Weise lässt sich die Isolierung isolierter Leitungsdrähte besonders schnell, einfach und kostengünstig und ohne den Einsatz eines Lasers oder einer Leitungsdrahtabisolierungsvorrichtung entfernen.

In einer weiteren bevorzugten Ausführungsform kann die Polungsrichtung des zum Leitungsdraht positionierbaren Elektrodenpaares während des Abisolierens periodisch gewechselt werden. Hierdurch kann der ungleichmäßige Elektrodenabbrand während des Abisoliervorgangs vermieden werden.

In einer weiteren bevorzugten Ausführungsform kann ein zum Leitungsdraht positionierbares Elektrodenpaar zum Durchgangsschweißen gleich gepolt und parallel geschaltet werden. Hierdurch kann ohne Neupositionierung mit demselben Elektrodenpaar der Abisoliervorgang des Leitungsdrahts und die im Durchgangs-KontaktSchweißverfahren durchgeführten Verschweißung des Leitungsdrahts mit der leitfähigen Folie äußerst schnell, kostengünstig und effizient vorgenommen werden.

In einer weiteren bevorzugten Ausführungsform kann der Leitungsdraht zumindest während des Verschweißvorgangs durch eine Andrückvorrichtung gespannt und niedergehalten werden. Durch den Einsatz einer solchen Andrückvorrichtung kann ein Abheben oder Verziehen des Leitungsdrahtes während des Verschweißvorgangs und eine unsaubere Verlegung des Leitungsdrahts insbesondere nach Abtrennen des Leitungsdrahtes von einer Leitungsdrahtzuführungsvorrichtung sowie eine Schlechtschweißung vermieden werden.

In einer weiteren bevorzugten Ausführungsform kann der Leitungsdraht stellenweise verklebt werden, vorzugsweise an Stellen, an welchen die Leitungsdrahtverlegerichtung geändert wird. Auf diese Weise kann eine saubere und flache Verlegung der Leitungsdrähte durch diese Art der Fixierung gewährleistet werden und so auch ein "orthogonales Wire-Routing" vorgenommen oder ungünstige Leitungsdrahtkreuzungen oder Juxtapositionen oder die Leitungsdrahtverlegung beispielsweise in Bohrungs- oder Durchkontaktierungsbereichen vermieden werden. Dabei ist es sowohl möglich, das Klebemittel an den vom Verdrahtungs- oder Wirerouting-Layout vorgegebenen Positionen während des Drahtschreibens aber bereits vor Positionierung des Leitungsdrahtes oder in einem vorangegangenen Arbeitsschritt gezielt aufzubringen oder die leitfähige Folie mit einer festen Klebepunkt- oder Klebeflächenstruktur auszustatten bzw. vorzukonfektionieren und so die nachfolgend verlegten Leitungsdrähte sicher zu fixieren.

In einer weiteren bevorzugten Ausführungsform kann das Klebemittel an den Verklebungsstellen vorzugsweise durch Auftropfen, Ausdüsen oder Aufsprühen aufgebracht werden. Hierdurch kann das Klebemittel lokal sehr präzise appliziert und zwischen Leitungsdraht und leitfähiger Folie eingebracht werden.

In einer weiteren bevorzugten Ausführungsform kann das Klebemittel durch Eintrag elektromagnetischer Energie, vorzugsweise durch UV-Strahlung aktivierbar und/oder vernetzbar und/oder in seiner Abbindung beschleunigbar sein. Durch den Einsatz eines solchen Klebemittels können die Abbindezeiten stark verkürzt und teilweise unter einer Sekunde gehalten werden, was für die schnelle Automatendrahtverschreibung von großem Vorteil ist.

In einer weiteren bevorzugten Ausführungsform kann ein Verfahren zur durchgehenden Verlegung eines isolierten Leitungsdrahtes zwischen auf einer Leiterplatte angeordneten elektrischen Anschlussstellen mittels einer numerisch gesteuerten Vorrichtung durchgeführt werden, welches wenigstens die folgenden Schritte beinhaltet:
a) Abisolieren des Leitungsdrahts an einem zum Anschluss an eine Anfangsanschlussstelle vorgesehenen Anschlussabschnitt;
b) Erzeugen einer Relativbewegung zwischen der Leiterplatte und zumindest dem Anschlussabschnitt des Leitungsdrahts, um den Anschlussabschnitt des Leitungsdrahts an der Anfangsanschlussstelle auf der Leiterplatte zu positionieren;
c) stoffschlüssiges Verbinden des Anschlussabschnitts des Leitungsdrahts mit der Anfangsanschlussstelle;
d) Erzeugen einer Relativbewegung zwischen dem Leitungsdraht und der Leiterplatte unter Vorschub einer zu verlegenden Leitungsdrahtlänge, um einen weiteren Anschlussabschnitt des Leitungsdrahts an einer weiteren Anschlussstelle auf der Leiterplatte zu positionieren;
e) Abisolieren des an der weiteren Anschlussstelle positionierten Anschlussabschnitts des Leitungsdrahts;
f) stoffschlüssiges Verbinden des Anschlussabschnitts des Leitungsdrahts mit der weiteren Anschlussstelle;
g) Fortfahren mit den Schritten d) bis f) solange, bis eine Endanschlussstelle erreicht ist;
h) Abtrennen der verlegten Leitungsdrahtlänge, wobei
i) die Reihenfolge der Schritte a) und b) und/oder die Reihenfolge der Schritte d) und e) miteinander vertauschbar ist.

Durch ein solches Verfahren sind sowohl die Prototypenfertigung, die Kleinserienfertigung wie auch die industrielle Fertigung drahtverschriebener Platinen kostengünstig und effizient durchführbar.

Die mit diesem Verfahren zu erzielenden Vorteile sind insbesondere darin zu sehen, dass der Drahtschreibevorgang vollständig automatisiert ist und keine weiteren Eingriffe seitens des Bedienpersonals notwendig sind, um eine nach beliebiger Vorgabe erstellte drahtbeschriebene Leiterplatte herzustellen. Weiterhin wird der Leitungsdraht von der Anfangsanschlussstelle über eventuelle weitere Anschlussstellen bis zur Endanschlussstelle ohne Unterbrechung durchgehend verlegt, wodurch eventuell auftretende Kontaktprobleme drastisch reduziert werden. Mit dem Verfahren sind eine beliebige Anzahl von Leitungsdrähten jeweils zwischen einer Anfangsanschlussstelle und einer Endanschlussstelle auf einer leitfähigen Folie schreibbar, insbesondere auch in mehreren Schichten übereinander.

Besonders bevorzugt erfolgt die Relativbewegung zwischen dem Leitungsdraht und der Leiterplatte durch eine Bewegung der Leiterplatte innerhalb einer horizontalen Ebene relativ zu einem den Leitungsdraht speichernden Leitungsdrahtspeicher. Zusätzlich können zumindest die Anschlussabschnitte des Leitungsdrahts relativ zur Leiterplatte positioniert werden. Eine solche Kinematik ist auf einfache Weise beispielsweise durch einen bei Werkzeugmaschinen üblichen Kreuztisch realisierbar, welcher bezüglich zweier in einer Ebene angeordneter Achsen angetrieben ist. Dabei kann jede Achse mit einer eigenen Lageregulierung versehen sein.

Gemäß dem Vorrichtungsaspekt zur Ausführung des erfindungsgemäßen Verfahrens sind ebenfalls mehrere Ausführungsformen denkbar, die in Auswahl im Folgenden beschrieben sind.

In einer bevorzugten Ausführungsform kann die Vorrichtung eine Einrichtung zum Abisolieren eines isolierten Leitungsdrahtes aufweisen. Hierdurch wird der Einsatz isolierten Leitungsdrahtes mit den vorerwähnten Vorteilen der zuverlässigen Vermeidung unerwünschter elektrischer Kontaktierungen zwischen Leitungsdrähten und Oberflächenleiterbahnen der fertigen Platine sowie zwischen Leitungsdrähten untereinander in Verbindung mit dem vorgenannten automatisierten Verfahren möglich.

In einer weiteren bevorzugten Ausführungsform kann die Vorrichtung eine Einrichtung zum Abtrennen des Leitungsdrahtes aufweisen. Hierdurch kann eine zuverlässige automatische Ablängung des Leitungsdrahts in Leitungsdrahtverlegerichtung hinter der Verbindungsstelle mit der leitfähigen Folie zuverlässig vorgenommen werden.

In einer weiteren bevorzugten Ausführungsform kann die Einrichtung zur Erzeugung der Relativbewegung zwischen der Leiterplatte und dem Leitungsdrahtspeicher, einen die leitfähigen Folie spannenden und wenigstens zwei horizontalen Achsen (X, Y) verfahrbaren Kreuztisch, einen relativ zum Kreuztisch entlang einer vertikalen Achse (z) verfahrbaren, die Einrichtung zum Abisolieren von Leitungsdraht, die Einrichtung zum stoffschlüssigen Verbinden von Leitungsdraht mit elektrischen Anschlussstellen auf der leitfähigen Folie sowie die Einrichtung zum Abtrennen von Leitungsdraht, tragendem Schlitten und einem im Bezug zum Schlitten durch das Steuergerät schwenkbar antreibbaren, den Leitungsdrahtspeicher tragenden Schwenkarm beinhalten. Auf diese Weise kann eine zuverlässige und kostengünstig zu fertigende Vorrichtung zur Ausführung des erfindungsgemäßen Verfahrens hergestellt werden.

In einer weiteren bevorzugten Ausführungsform kann der Leitungsdrahtspeicher durch eine Leitungsdrahtspeicherrolle gebildet werden, welche mittels des Schwenkarms quer zur momentanen Verlegerichtung des Leitungsdrahts verschwenkbar ist. Auf diese Weise kann die Leitungsdrahtabrollvorrichtung der Verlegerichtung des Leitungsdrahts angepasst werden.

In einer weiteren bevorzugten Ausführungsform kann weiterhin eine durch Steuergeräte ansteuerbare Einrichtung zum Erzeugen von Drahtvorschub beinhaltet sein, die an dem Schwenkarm festgelegt ist. Durch den gezielten Drahtvorschub kann die Spannung des Leitungsdrahts beim Ausspannen zwischen den Anschlussstellen gezielt an die Erfordernisse optimaler Fertigungsqualität und Geschwindigkeit angepasst werden.

So ist es in der Regel zweckmäßig, durch das Steuergerät die Einrichtung zur Erzeugung von Drahtvorschub während des Schreibens des Leitungsdrahtantriebs drehmomentlos zu schalten, oder mit einem nur geringen Drehmoment zu beaufschlagen, um so den Leitungsdraht nach seiner Festlegung durch Verschweißen mit der ersten Anschlussstelle entsprechend dem Routingverlauf aufzuspannen und zu verlegen. Um den Leitungsdraht nach dem Abtrennen vom verlegten oder geschriebenen Leitungsdrahtabschnitt zu fassen und zu halten, wird der wirksame Freilauf der Rollen der Drahtvorschubeinrichtung aufgehoben und so ein unkontrolliertes Abrollen an der Leitungsdrahtspeicherrolle verhindert.

In einer bevorzugten Ausführungsform kann eine durch das Steuergerät ansteuerbare Klebeeinrichtung zum Verkleben des Leitungsdrahts mit der Leiterplatte an Stellen vorgesehen sein, an welchen der Leitungsdraht eine Richtungsänderung erfährt. Durch eine solche ansteuerbare Klebeeinrichtung können gezielt Klebepunkte gesetzt und so die präzise Verlegung der Leitungsdrähte durch diese Art der Fixierung gewährleistet werden, um so beispielsweise ein "orthogonale Wire-Routing" vorzunehmen oder ungünstige Leiterkreuzungen oder Juxtapositionen der Leitungsdrähte oder Leitungsdrahtverlegung beispielsweise im Bereich von Bohrungen oder Durchkontaktierungen zu vermeiden.

In einer weiteren bevorzugten Ausführungsform kann die Vorrichtung eine thermische Trennplatte aufweisen. Auf diese Weise lässt sich eine besonders hohe Schweißstellenqualität und die Verschweißung einer großen Bandbreite an Leitungsdrahtquerschnitten und -stärken auf handelsüblichen, zur Herstellung von Leiterplatten vorgesehenen, leitfähigen Folien zuverlässig durchführen.

In einer weiteren bevorzugten Ausführungsform kann die Vorrichtung eine Einrichtung zum Spannen und/oder Niederhalten des Leitungsdrahtes aufweisen, wodurch sich eine besonders zuverlässige und präzise Verlegung des Leitungsdrahtes und eine weitgehende Vermeidung von Schlechtschweißungen erzielen lässt.

Die vorstehend ausgeführten Ausgestaltungen der Erfindung stellen lediglich eine Auswahl zweckmäßiger Gestaltungsmöglichkeiten des Erfindungsgegenstandes dar, die in den einzelnen Unteransprüchen niedergelegt sind. Diese speziellen Gestaltungsmöglichkeiten können einzeln oder, soweit technisch möglich und sinnvoll, auch in Kombination mehrerer der vorerwähnten Gestaltungsvarianten mit einem Verfahren gemäß dem Anspruch 1 bzw. einer Vorrichtung zum Durchführen des Verfahrens nach Anspruch 25 Anwendung finden. Nachfolgend wird die Erfindung beispielhaft anhand bevorzugter Ausführungsbeispiele in Verbindung mit den dazugehörigen Figuren näher erläutert. Es zeigen:
- Fig. 1: eine perspektivische Ansicht einer Vorrichtung zur Verlegung eines isolierten Leitungsdrahtes zwischen zur Ausbildung elektrischer Anschluss-stellen vorgesehener Bereiche einer leitfähigen Folie gemäß einer bevorzugten Ausführungsform der Erfindung;
- Fig. 2: eine schematische Darstellung der Vorrichtung von Fig. 1 während eines Fertigungsschritts;
- Fig. 3: eine schematische Darstellung der Vorrichtung von Fig. 1 während eines weiteren Fertigungsschritts;
- Fig. 4: eine schematische Darstellung der Vorrichtung von Fig. 1 während eines weiteren Fertigungsschritts;
- Fig. 5: eine schematische Darstellung der Vorrichtung von Fig. 1 während eines weiteren Fertigungsschritts.

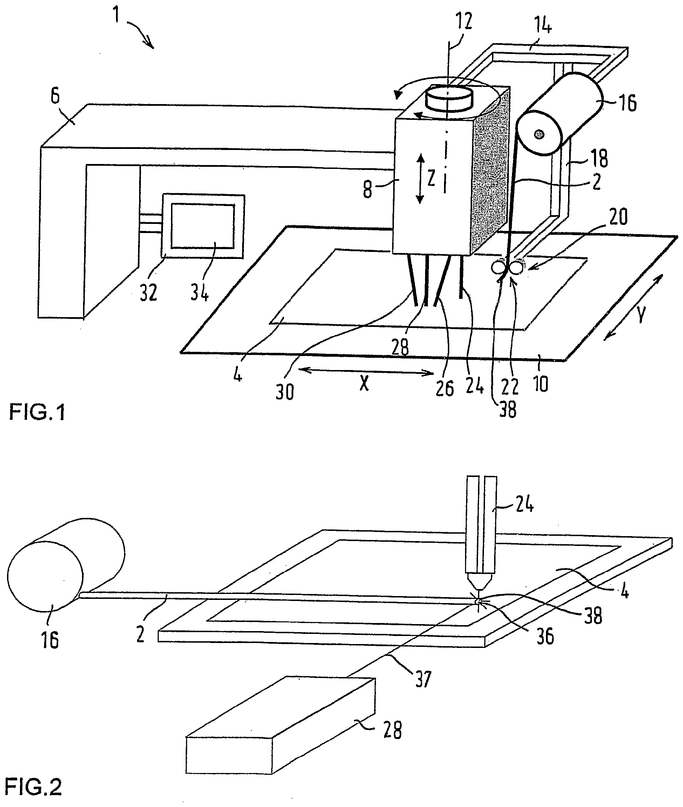

Die in Fig. 1 insgesamt mit 1 bezeichnete Vorrichtung gemäß einer bevorzugten Ausführungsform der Erfindung dient zur Verlegung eines Leitungsdrahts 2, der von einer Isolierung umgeben sein kann, zwischen wenigstens zwei zur Ausbildung elektrischer Anschlussstellen vorgesehener Bereiche einer leitfähigen Folie, die nach Verbindung mit einem Leiterplattenträger mit diesem zur Ausbildung einer Leiterplatte bestimmt ist. Diese diskreten, zur Ausbildung von Anschlussstellen bestimmten Bereiche werden - in gleicher Weise wie eventuell auf der Platine vorgesehene Leiterbahnen - in einem nachfolgenden Schritt nach Verbindung der leitfähigen Folie mit einem Leiterplattenträger zu einer Leiterplatte beispielsweise durch partielle Abätzung oder Wegätzung der mit dem Leiterplattenträger verbundenen leitfähigen Folie verinselt und so elektrisch voneinander isoliert. Der Begriff "Anschlussstelle" ist dabei im weitesten Sinne zu verstehen, d.h. er soll sämtliche elektrischen Anschlussmöglichkeiten eines Leitungsdrahtes 2 auf der leitfähigen Folie 4 zur Kaschierung einer Leiterplatte bzw. an auf der leitfähigen Folie oder einer Trägerfolie angeordneten Kontaktierungsbereichen oder auf der zu fertigenden Leiterplatte angeordneten Kontakt- oder Leitungsstrukturen, elektrischen oder elektronischen Bauelementen, mechanischen Komponenten oder sonstigen zum Anschluss von Leitungsdrähten 2 geeigneten Strukturen umfassen.

Die leitfähige Folie 4 ist über eine thermische Trennplatte 10 auf einen Kreuztisch gespannt und so gegenüber einem an einem Ständer 6 verfahrbaren Schlitten 8 in einer horizontalen Ebene positionierbar, beispielsweise dadurch, dass der Kreuztisch bezüglich zweier in der horizontalen Ebene angeordneter Achsen X und Y angetrieben ist. Dabei kann jede Achse X, Y mit einer eigenen Lageregelung versehen sein.

Der Ständer 6 ist an einem Gestell der Vorrichtung 1 befestigt und beispielsweise L-förmig ausgebildet. An ihm ist der Schlitten 8 entlang einer vertikalen Z-Achse verfahrbar, welche ebenfalls mit einer Lageregelung ausgestaltet sein kann. An dem Schlitten 8 ist ein um eine vertikale Schwenkachse 12 schwenkbarer drehangetriebener Schwenkarm 14 drehgelagert, welcher eine Leitungsdrahtspeicherrolle 16 trägt, auf welche eine bestimmte Menge an Leitungsdraht 2 aufgewickelt ist. Der Schwenkarm 14 trägt außerdem an einem sich vertikal in Richtung der Leiterplatte 4 nach unten erstreckenden Ausleger 8 eine Drahtvorschub- und Justiereinrichtung 20, welche Leitungsdraht 2 von der Leitungsdrahtspeicherrolle 16 abrollen kann. Diese Funktion ist beispielsweise durch zwei angetriebene Rollen 22 verwirklicht, welche je nach Drehrichtung den zwischen sich geführten Leitungsdraht 2 vorschieben oder zurückziehen. Darüber hinaus können diese Rollen 22 auch in einen Freilauf geschaltet werden oder definierbar gebremst werden, um keinen Widerstand oder einen geringen definierten Widerstand auf den Leitungsdraht 2 auszuüben, wenn dieser nach Befestigung an einer Anschlussstelle auf der Leiterplatte 4 mittels einer Bewegung des Kreuztischs relativ zur Drahtvorschub- und Justiereinrichtung 20, welche ihn dann lediglich führt, von der Leitungsdrahtspeicherrolle 16 abgewickelt wird.

Darüber hinaus trägt der Schlitten 8 beispielsweise an seiner zur leitfähigen Folie 4 weisenden Stirnfläche eine Einrichtung zum stoffschlüssigen Verbinden von Leitungsdraht mit den elektrischen Anschlussstellen auf der Leiterplatte, welche beispielsweise durch eine Schweißeinrichtung 24 mit Schweißkopf realisiert ist, ferner eine Klebeeinrichtung 26 zum Kleben von Leitungsdraht 2 auf die leitfähige Folie 4, vorzugsweise mit schnellhärtendem UV-Kleber, eine Abisoliereinrichtung 28 zum Abisolieren des Leitungsdrahts 2 beispielsweise durch ein thermisches Verfahren mittels Laser oder durch Abbrennen mittels der Schweißelektroden oder durch ein mechanisches Verfahren durch entsprechend angeordnete Schneidklingen oder rotierende Schneidwalzen oder durch Press- oder Schabquetschung mittels der Schweißelektroden, sowie eine Trenneinrichtung 30 zum Abtrennen von abgewickeltem Leitungsdraht 2 von dem auf der Leitungsdrahtspeicherrolle 16 verbleibenden Restdraht. Weiterhin umfasst die Vorrichtung eine Andrückeinrichtung 31 mittels derer der Leitungsdraht 2 beispielsweise auch nach dessen Abtrennen von dem auf der Leitungsdrahtspeicherrolle 16 verbleibenden Restdraht 42 bis zur Verschweißung zuverlässig gespannt und niedergehalten werden kann.

Die genannten, am Schlitten 8 vorzugsweise stirnseitig angeordneten Einrichtungen 24, 26, 28, 30 weisen in ihrer Grundstellung einen gewissen vertikalen Abstand zur leitfähigen Folie bzw. zu den als Anschlussstellen vorgesehenen Bereichen auf dieser leitfähigen Folie 4 auf, so dass erst durch einen Antrieb des Schlittens entlang der vertikalen Z-Achse in Richtung auf die leitfähige Folie 4 der Abstand bzw. der Kontakt mit der jeweiligen Arbeitsstelle hergestellt wird, welcher für den jeweiligen Bearbeitungsschritt notwendig ist. Die Schwenkachse 12 des Schwenkarms 14 befindet sich in unmittelbarer Nähe zu den stirnseitig am Schlitten angeordneten Einrichtungen 24, 26, 28, 30, so dass die am Ausleger 18 des Schwenkarms 14 befestigte, das freie Ende 38 des Leitungsdrahts 2 umfassende Drahtvorschub- und Justiereinrichtung 20 unabhängig von der Drehstellung des Schwenkarmes 14 ungefähr stets den gleichen radialen Abstand von diesen Einrichtungen 24, 26, 28, 30 aufweist.

Alle genannten Einrichtungen 8, 10, 14, 20, 22, 24, 26, 28, 30 und 31 der Vorrichtung 1 werden von einer mikroprozessorbasierten, numerischen Steuerung (CNC) angesteuert, in deren zentrales Steuergerät 32 über eine Eingabeeinheit 34 die Daten betreffend die Verlege- oder Schreibstruktur des Leitungsdrahtes 2 auf der leitfähigen Folie 4 einlesbar sind.

Der Ausgangspunkt ist ein Grundzustand der Vorrichtung 1, bei welchem eine leitfähige Folie 4, auf deren Oberfläche die elektrischen Anschlussstellen über den Leitungsdraht vorbestimmt sind, zusammen mit der thermischen Trennplatte und ggf. einen als Stromverteilungsvorrichtung dienenden Kupferblock auf den Kreuztisch gespannt ist. Weiterhin ist ein Ende 38 des ein Stück weit von der Leitungsdrahtspeicherrolle 16 abgewickelten Leitungsdrahts 2 in die Drahtvorschub- und Justiereinrichtung 20 eingelegt. Schließlich sind über die Eingabeeinheit 34 die Daten betreffend die Verlege- oder Schreibstruktur des Leitungsdrahtes 2 auf der leitfähigen Folie 4 in das Steuergerät 32 eingelesen worden.

Vor diesem Hintergrund ist die Funktionsweise der Vorrichtung 1 wie folgt: Das Steuergerät 32 steuert ein Steuersignal an den Antrieb des Schwenkarms 14 aus, um die Leitungsdrahtspeicherrolle 16 rechtwinklig zur Richtung des Drahtschreibens oder Drahtverlegens zu positionieren. Danach wird der Leitungsdraht 2 durch einen entsprechenden Antrieb der x- und γ-Achse des Kreuztischs sowie durch einen mit Hilfe der Drahtvorschub- und Justiereinrichtung 20 eingeleiteten Vorschub über der Anfangsanschlussstelle 36 auf der leitfähigen Folie 4 positioniert. Danach wird das einen Anschlussabschnitt darstellende Ende 38 des Leitungsdrahts 2 durch die Abisoliereinrichtung 28 abisoliert, beispielsweise indem ein Laserstrahl 37 den Isoliermantel aus Kunststoff vom Leitungsdraht 2 stellenweise abschmilzt. Alternativ kann selbstverständlich zuerst der Abisoliervorgang und danach der Positioniervorgang erfolgen. Anschließend wird der Schlitten 8 entlang der vertikalen Z-Achse angetrieben und der Schweißkopf der Schweißeinrichtung 24 auf das Niveau der Anfangsanschlussstelle abgesenkt. Durch Aktivieren des Schweißkopfes wird das abisolierte Ende 38 des Leitungsdrahtes 2 mit der ersten Anschlussstelle 36 verschweißt und somit unlösbar mit der auf der leitfähigen Folie 4 oder auf der Trägerfolie angeordneten Anschlussstelle verbunden. Dieser Vorgang ist in Fig. 2 schematisch gezeigt. Hierauf werden die Rollen der Drahtvorschub- und Justiereinrichtung 20 antriebs- und drehmomentlos geschaltet, damit der Leitungsdraht zum weiteren Schreiben bzw. Verlegen freilaufen kann, denn eine Lagefixierung des Leitungsdrahts 2 ist bereits durch die Befestigung an der Anschlussstelle 36 erreicht.

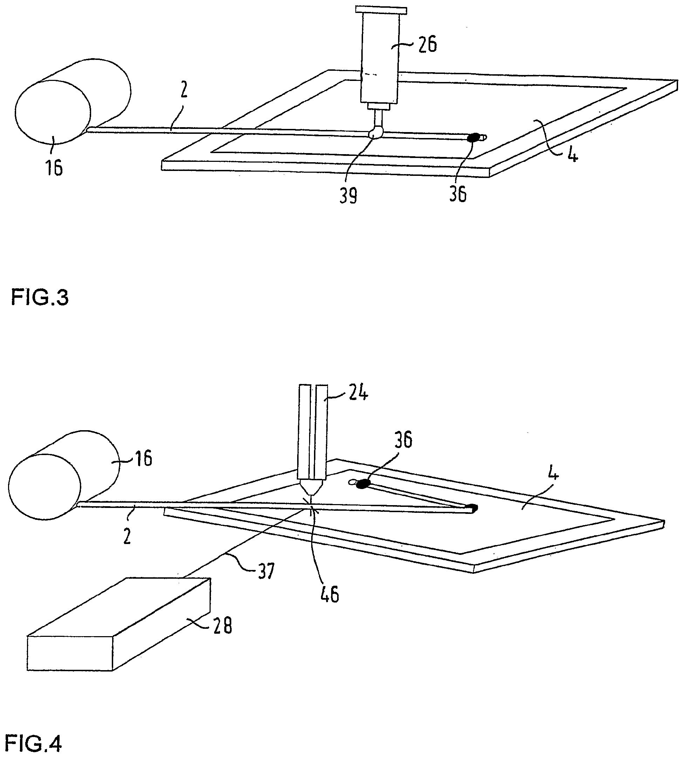

Um eine weitere Anschlussstelle der leitfähigen Folie 4 anzufahren wird der Kreuztisch vom Steuergerät 32 entsprechend angesteuert und hierdurch der Leitungsdraht 2 auf die Trägerfolie geschrieben oder auf ihr verlegt. Sind während des Drahtschreibens Richtungsänderungen im Bezug auf die kürzeste Verbindung zwischen der letzten Anschlussstelle und der nächsten Anschlussstelle notwendig, beispielsweise um zu vermeiden, dass Anschlussstellen durch elektronische Bauelemente vom Leitungsdraht 2 überdeckt werden, wird der Antrieb des Kreuztisches deaktiviert und der Leitungsdraht 2 durch die Klebeeinrichtung 26 auf der leitfähigen Folie fixiert, indem der Schlitten entlang der Z-Achse angetrieben und die Klebeeinrichtung 26 auf das Niveau der leitfähigen Folie 4 abgesenkt wird, um einen Klebepunkt zu setzen. Dieser Schritt ist in Fig. 3 schematisch dargestellt. Je nach Notwendigkeit kann sich dieser Schritt mehrmals wiederholen.

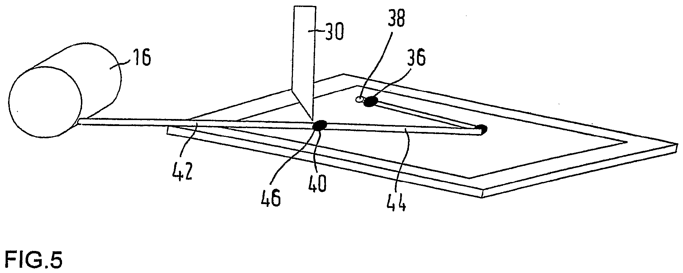

Nach erfolgter Klebung wird durch Antrieb des Kreuztisches der Leitungsdraht 2 weiter auf der leitfähigen Folie fortgeschrieben, bis die nächste Anschlussstelle erreicht ist. Dort wird wiederum die Abisoliereinrichtung 28 und die Schweißeinrichtung 24 aktiviert, um einen Stoffschluss des Leitungsdrahts 2 mit der Anschlussstelle zu verwirklichen. Die genannten Schritte werden solange wiederholt, bis eine Endanschlussstelle 40 erreicht ist. Dort wird ein weiterer Anschlussabschnitt 46 des Leitungsdrahts 2 nach Absenken des Schlittens 8 auf Leiterplattenniveau durch die Abisoliereinrichtung 28 abisoliert und durch die Schweißeinrichtung 24 unlösbar mit der leitfähigen Folie 4 verbunden, wie aus Fig. 4 hervorgeht. Um den Leitungsdraht 2 wieder zu fassen, wird der bisher wirksame Freilauf der Rollen 22 der Drahtvorschub- und Justiereinrichtung 20 aufgehoben, wodurch verhindert wird, dass der sich zwischen der Endanschlussstelle 40 und der Leitungsdrahtspeicherrolle 16 erstreckende Leitungsdrahtabschnitt 42 nach dem Abtrennen vom verlegten oder geschriebenen Leitungsdraht 44 unkontrolliert von der Leitungsdrahtspeicherrolle 16 abrollen kann. Abschließend wird der geschriebene oder verlegte Leitungsdrahtabschnitt 44 unmittelbar hinter der Endanschlussstelle 40 durch die Trenneinrichtung 30 von der der Leitungsdrahtspeicherrolle 16 zugeordneten Restlänge abgetrennt, wie Fig. 5 zeigt.

Anstatt die Drahtverschreibung auf einer durchgehenden leitfähigen Folie 4 auszuführen ist es auch möglich, bereits diskrete Anschlussstrukturen und eventuell zur Verlegung an der Oberfläche der später durch Verbinden mit dem Leiterplattenträger herzustellenden Leiterplatte vorgesehene sonstige leitfähige Strukturen beispielsweise auf eine Trägerfolie zu übertragen oder anderweitig anzuordnen und in geeigneter Weise zu fixieren und in diesem Zustand der Drahtschreibung des Leitungsdrahts 2 zu unterziehen, wodurch eine sehr große Bandbreite unterschiedlicher Anschlussstrukturen und Oberflächenleiterstrukturierung auf einer Leiterplatte, durch Verbinden mit einem Leiterplattenträger hergestellt werden können.

Gemäß der Variante, bei der die Drahtschreibung auf einer durchgehenden leitfähigen Folie erfolgt, werden die zu Anschluss- und Leitungszwecken zur Anordnung auf der Leiterplattenoberfläche vorgesehenen Anschluss- und Leitungsstrukturen nach dem Verlegen bzw. Drahtschreiben des Leitungsdrahts 2 beispielsweise durch ein Ätzverfahren voneinander getrennt und gegeneinander isoliert, um so die Anschlussstellen 36, 40 aus der Kupferfolie herauszuarbeiten. Da diese jedoch gemäß des vorhandenen Schaltungslayouts bereits vorab bekannt sind, können die Verbindungen des Leitungsdrahts 4 mit den noch nicht diskretisierten Anschlussstellen 36, 40 bereits vorab gefertigt werden. Zusätzlich kann die mit dem Leitungsdraht 2 versehene Oberfläche der leitfähigen Folie 4 mit einer Stabilisierungs- und Isolierungsdeckschicht versehen werden, beispielsweise dadurch, dass ein Prepreg aus Isolierstoffmasse und Armierungsmaterial mit der leitfähigen Folie 4 zu einer Leiterplatte verpresst oder vergossen wird.

Es ist klar, dass die beschriebenen Funktionen auch durch eine Vorrichtung 1 ausgeführt werden können, welche eine andere Kinematik als die oben beschriebene aufweist. Insbesondere kann gemäß einer weiteren Ausführungsform beispielsweise die leitfähige Folie stationär angeordnet und sämtliche Bewegungen durch einen in drei Achsen angetriebenen Schlitten ausgeführt werden.

## Patentansprüche

1. Verfahren zum Verschweißen eines Leitungsdrahts mit auf einer leitfähigen Folie angeordneten elektrischen Anschlussstellen, wobei die leitfähige Folie zur Verbindung mit einem Leiterplattenträger zur Herstellung einer Leiterplatte bestimmt ist, und wobei die Dicke oder der Durchmesser des Leitungsdrahtes vorzugsweise größer ist als die Dicke der leitfähigen Folie, **dadurch gekennzeichnet, dass** die leitfähige Folie sich während des Verschweißens mit einer thermischen Trennplatte in Kontakt befindet, deren Wärmeleitfähigkeit geringer ist als die der leitfähigen Folie, und wobei gesondert von der thermischen Trennplatte, in einem nachfolgenden Schritt, nach Verbindung der leitfähigen Folie mit einem Leiterplattenträger zu einer Leiterplatte, zur Ausbildung von den Anschlussstellen vorgesehene Bereiche durch partielle Abätzung oder Wegätzung der mit dem Leiterplattenträger verbundenen leitfähigen Folie verinselt und so elektrisch voneinander isoliert werden.

2. Verfahren zum Verschweißen eines Leitungsdrahts mit einer leitfähigen Folie nach Anspruch 1, **dadurch gekennzeichnet, dass** die Wärmeleitfähigkeit der thermische Trennplatte - zumindest in einer um den Verschweißungsbereich gelegenen Region - mindestens um den Faktor 2, vorzugsweise mindestens um den Faktor 5 geringer ist, als die der leitfähigen Folie.

3. Verfahren zum Verschweißen eines Leitungsdrahts mit einer leitfähigen Folie nach Anspruch 1 oder 2, **dadurch gekennzeichnet, dass** die thermische Trennplatte eine höhere Schmelztemperatur und eine höhere thermische Beständigkeit aufweist als die der leitfähigen Folie und/oder die Temperaturbelastung während des Verschweißvorgangs.

4. Verfahren zum Verschweißen eines Leitungsdrahts mit einer leitfähigen Folie nach zumindest einem der vorangegangenen Ansprüche, **dadurch gekennzeichnet, dass** die thermische Trennplatte zumindest in einem um den Verschweißungsbereich gelegenen Kontaktbereich mit der leitfähigen Folie, vorzugsweise im gesamten Auflagebereich der leitfähigen Folie eine Beschichtung mit höherer thermischer Beständigkeit und/oder geringer thermischer Leitfähigkeit aufweist als das Grundmaterial.

5. Verfahren zum Verschweißen eines Leitungsdrahts mit einer leitfähigen Folie nach zumindest einem der vorangegangenen Ansprüche, **dadurch gekennzeichnet, dass** die thermische Trennplatte zumindest in einem um den Verschweißungsbereich gelegenen Kontaktbereich zur leitfähigen Folie, vorzugsweise im gesamten Auflagebereich der leitfähigen Folie, eine Inertoberfläche, vorzugsweise in Form einer Inertbeschichtung aufweist.

6. Verfahren zum Verschweißen eines Leitungsdrahts mit einer leitfähigen Folie nach zumindest einem der vorangegangenen Ansprüche, **dadurch gekennzeichnet, dass** die thermische Trennplatte elektrisch leitfähig ist.

7. Verfahren zum Verschweißen eines Leitungsdrahts mit einer leitfähigen Folie nach zumindest einem der vorangegangenen Ansprüche, **dadurch gekennzeichnet, dass** die Dicke der thermische Trennplatte vorzugsweise um mindestens den Faktor 5 und höchstens den Faktor 300 größer ist als die der leitfähigen Folie.

8. Verfahren zum Verschweißen eines Leitungsdrahts mit einer leitfähigen Folie nach zumindest einem der vorangegangenen Ansprüche, **dadurch gekennzeichnet, dass** die thermische Trennplatte zwischen der leitfähigen Folie und einer Stromverteilungsvorrichtung vorzugsweise aus einem Cu-Block angeordnet ist.

9. Verfahren zum Verschweißen eines Leitungsdrahts mit einer leitfähigen Folie nach zumindest einem der vorangegangenen Ansprüche, **dadurch gekennzeichnet, dass** die Dicke oder der Durchmesser des zu verschweißenden Leitungsdrahts vorzugsweise um den Faktor 2 bis 10 größer ist als die Dicke der leitfähigen Folie.

10. Verfahren zum Verschweißen eines Leitungsdrahts mit einer leitfähigen Folie nach zumindest einem der vorangegangenen Ansprüche, **dadurch gekennzeichnet, dass** an die Verschweißstelle eine weitere, von Draht und/oder Platte verschiedene metallische Komponente eingebracht wird.

11. Verfahren zum Verschweißen eines Leitungsdrahts mit einer leitfähigen Folie nach zumindest einem der vorangegangenen Ansprüche, **dadurch gekennzeichnet, dass** der Draht mindestens ein weitere, von Draht und/oder Platte verschiedene metallische Komponente, vorzugsweise in Form eines metallischen Überzugs, insbesondere aus Ag oder Sn aufweist.

12. Verfahren zum Verschweißen eines Leitungsdrahts mit einer leitfähigen Folie nach zumindest einem der vorangegangenen Ansprüche, **dadurch gekennzeichnet, dass** die Verschweißung durch ein Kontaktschweißverfahren vorgenommen wird.

13. Verfahren zum Verschweißen eines Leitungsdrahts mit einer leitfähigen Folie nach zumindest einem der vorangegangenen Ansprüche, **dadurch gekennzeichnet, dass** die Gegenelektrode im Bezug auf die Ebene der Platte der Schweißelektrode gegenüberliegend angeordnet ist.

14. Verfahren zum Verschweißen eines Leitungsdrahts mit einer leitfähigen Folie nach zumindest einem der vorangegangenen Ansprüche, **dadurch gekennzeichnet, dass** zwei schweißstromführende Elektroden im Bezug auf die Ebene der Kontaktfläche zwischen leitfähiger Folie und thermische Trennplatte auf derselben Seite angeordnet sind.

15. Verfahren zum Verschweißen eines Leitungsdrahts mit einer leitfähigen Folie nach zumindest einem der vorangegangenen Ansprüche, **dadurch gekennzeichnet, dass** zwei Schweißelektroden im Bezug auf den Leitungsdraht positionierbar sind.

16. Verfahren zum Verschweißen eines Leitungsdrahts mit einer leitfähigen Folie nach zumindest einem der vorangegangenen Ansprüche, **dadurch gekennzeichnet, dass** die Gegenelektrode als Flächenelektrode ausgebildet und im Bezug auf die Ebene der thermischen Trennplatte der Schweißelektrode auf derselben Seite angeordnet ist.

17. Verfahren zum Verschweißen eines Leitungsdrahts mit einer leitfähigen Folie nach zumindest einem der vorangegangenen Ansprüche, **dadurch gekennzeichnet, dass** ein Abisolieren isolierter Leitungsdrähte durch thermisches Abschmelzen und/oder durch mechanisches Abtragen, Abziehen oder Abquetschen, vorzugsweise durch thermisches Abschmelzen mittels eines Lasers oder durch Abbrennen mittels der Schweißelektroden, vorgenommen wird.

18. Verfahren zum Verschweißen eines Leitungsdrahts mit einer leitfähigen Folie nach zumindest einem der vorangegangenen Ansprüche, **dadurch gekennzeichnet, dass** das Abschmelzen der Isolierung durch ein zum Leitungsdraht positionierbares Elektrodenpaar vorzugsweise unter Steuerung und Überwachung von Prozessparametern vorgenommen wird.

19. Verfahren zum Verschweißen eines Leitungsdrahts mit einer leitfähigen Folie nach zumindest einem der vorangegangenen Ansprüche, **dadurch gekennzeichnet, dass** die Polungsrichtung des zum Leitungsdraht positionierbaren Elektrodenpaares während des Abisolierens periodisches gewechselt wird.

20. Verfahren zum Verschweißen eines Leitungsdrahts mit einer leitfähigen Folie nach zumindest einem der vorangegangenen Ansprüche, **dadurch gekennzeichnet, dass** ein zum Leitungsdraht positionierbares Elektrodenpaar zum Durchgangsschweißen gleichgepolt und vorzugsweise parallelgeschaltet wird.

21. Verfahren zum Verschweißen eines Leitungsdrahts mit einer leitfähigen Folie nach zumindest einem der vorangegangenen Ansprüche, **dadurch gekennzeichnet, dass** der Leitungsdraht zumindest während des Verschweißungsvorgangs durch eine Andrückvorrichtung gespannt und niedergehalten wird.

22. Verfahren zum Verschweißen eines Leitungsdrahts mit einer leitfähigen Folie nach zumindest einem der vorangegangenen Ansprüche, **dadurch gekennzeichnet, dass** der Leitungsdraht stellenweise verklebt wird, vorzugsweise an Stellen, an welchen die Leitungsdrahtverlegerichtung geändert wird.

23. Verfahren zum Verschweißen eines Leitungsdrahts mit einer leitfähigen Folie nach zumindest einem der vorangegangenen Ansprüche, **dadurch gekennzeichnet, dass** das Klebemittel an den Verklebungsstellen vorzugsweise durch Auftropfen, Ausdüsen oder Aufsprühen aufgebracht wird.

24. Verfahren zum Verschweißen eines Leitungsdrahts mit einer leitfähigen Folie nach zumindest einem der vorangegangenen Ansprüche, **dadurch gekennzeichnet, dass** das Klebemittel durch Eintrag elektromagnetischer Energie, vorzugsweise durch UV-Strahlung aktivierbar und/oder vernetzbar und/oder in seiner Abbindung beschleunigbar ist.

25. Vorrichtung zur Ausführung des Verfahrens nach wenigstens einem der vorhergehenden Ansprüche, beinhaltend wenigstens folgende, durch ein elektronisches Steuergerät (32) numerisch gesteuerte Einrichtungen:
a) eine Einrichtung (8, 10, 14) zur Erzeugung einer Relativbewegung zwischen einer leitfähigen Folie (4) und einem Leitungsdrahtspeicher (16),
b) eine Einrichtung (24) zum stoffschlüssigen Verbinden von Leitungsdraht (2) mit elektrischen Anschlussstellen (36, 40) auf der leitfähigen Folie (4),
c) eine thermische Trennplatte zur Auflage der Folie, wobei die Wärmeleitfähigkeit der thermischen Trennplatte geringer ist als das Kupfer der leitfähigen Folie.
d) Sowie eine durch das Steuergerät (32) ansteuerbare Klebeeinrichtung (26) zum Verkleben des Leitungsdrahts (2) mit der leitfähigen Folie (4) an Stellen, an welchen der Leitungsdraht (2) eine Richtungsänderung erfährt.

26. Vorrichtung nach Anspruch 25, **dadurch gekennzeichnet, dass** die Vorrichtung eine Einrichtung (28) zum Abisolieren eines isolierten Leitungsdrahts (2) aufweist.

27. Vorrichtung nach zumindest einem der Ansprüche 25 oder 26, **dadurch gekennzeichnet, dass** die Vorrichtung eine Einrichtung (30) zum Abtrennen von Leitungsdraht (2) aufweist.

28. Vorrichtung nach zumindest einem der Ansprüche 25 bis 27, **dadurch gekennzeichnet, dass** die Einrichtung zur Erzeugung der Relativbewegung zwischen der leitfähigen Folie (4) und dem Leitungsdrahtspeicher (16) einen die leitfähige Folie (4) spannenden, in wenigstens zwei horizontalen Achsen (X, Y) verfahrbaren Kreuztisch (10), einen relativ zum Kreuztisch (10) entlang einer vertikalen Achse (Z) verfahrbaren, die Einrichtung (28) zum Abisolieren von Leitungsdraht (2), die Einrichtung (24) zum stoffschlüssigen Verbinden von Leitungsdraht (2) mit elektrischen Anschlussstellen (36, 40) auf der leitfähigen Folie (4) sowie die Einrichtung (30) zum Abtrennen von Leitungsdraht (2) tragenden Schlitten (8) und einen im Bezug zum Schlitten (8) durch das Steuergerät schwenkbar antreibbaren, den Leitungsdrahtspeicher (16) tragenden Schwenkarm (14) beinhaltet.

29. Vorrichtung nach zumindest einem der Ansprüche 27 bis 28, **dadurch gekennzeichnet, dass** der Leitungsdrahtspeicher durch eine Leitungsdrahtspeicherrolle (16) gebildet wird, welche mittels des Schwenkarms (16) quer zur momentanen Verlegerichtung des Leitungsdrahts (2) verschwenkbar ist.

30. Vorrichtung nach zumindest einem der Ansprüche 25 bis 29, **dadurch gekennzeichnet, dass** sie weiterhin eine durch die Steuergerät ansteuerbare Einrichtung (20) zum Erzeugen von Drahtvorschub beinhaltet, welche an dem Schwenkarm (14) festgelegt ist.

31. Vorrichtung nach zumindest einem der Ansprüche 25 bis 30, **dadurch gekennzeichnet, dass** die Vorrichtung eine Einrichtung zum Spannen und/oder Niederhalten des Leitungsdrahtes aufweist.

## Claims

1. Method for welding a conductor to electrical contact points arranged on a conductive film, wherein the conductive film is intended for connection to a circuit board support in order to produce a printed circuit board, the depth or diameter of the conductor being preferably larger than the thickness of the conductive film, **characterised in that** the conductive film is in contact with a thermal isolating plate during the welding process, the thermal conductivity of said plate being lower than that of the conductive film, and wherein, separated of the thermal conductivity plate, areas that are designated for the formation of connection points are, isolated in a subsequent step after connection of the conductive film to a circuit board support to form a printed circuit board, for example, by means of partially etching off or etching away the conductive film connected to the circuit board support, and so electrically isolated from one another.

2. Method for welding a conductor to a conductive film according to Claim 1, **characterised in that** the thermal conductivity of the thermal isolation plate is, at least in a region lying around the welding area, smaller than that of the conductive film by at least a factor of 2, preferably by at least a factor of 5.

3. Method for welding a conductor to a conductive film according to Claim 1 or 2, **characterised in that** the thermal isolation plate has a melting temperature and thermal stability that is greater than that of the conductive film and / or the temperature load during the welding process.

4. Method for welding a conductor to a conductive film according to at least one of the preceding claims, **characterised in that** the thermal isolation plate can have a coating with higher thermal stability and / or lower thermal conductivity than does the base material, at least in a contact area to the conductive film lying around the welding area, preferably in the entire contact area of the conductive film.

5. Method for welding a conductor to a conductive film according to at least one of the preceding claims, **characterised in that** the thermal isolation plate can have an inert surface, preferably in the form of an inert coating, at least in a contact area to the conductive film lying around the welding area, preferably in the entire contact area of the conductive film.

6. Method for welding a conductor to a conductive film according to at least one of the preceding claims, **characterised in that** the thermal isolation plate is electrically conductive.

7. Method for welding a conductor to a conductive film according to at least one of the preceding claims, **characterised in that** the thickness of the thermal isolation plate is preferably greater than that of the conductive film by at least a factor of 5 and by no more than a factor of 300.

8. Method for welding a conductor to a conductive film according to at least one of the preceding claims, **characterised in that** the thermal isolation plate is arranged between the conductive film and a power distribution device preferably made of a Cu block.

9. Method for welding a conductor to a conductive film according to at least one of the preceding claims, **characterised in that** the depth or diameter of the conductor that is to be welded is preferably larger than the thickness of the conductive film by a factor of from 2 to 10.

10. Method for welding a conductor to a conductive film according to at least one of the preceding claims, **characterised in that** a further metallic component that differs from the wire and / or board is introduced at the welding point.

11. Method for welding a conductor to a conductive film according to at least one of the preceding claims, **characterised in that** the wire has at least one additional metallic component that differs from the wire and / or board, preferably in the form of a metallic coating, particularly one of Ag or Sn.

12. Method for welding a conductor to a conductive film according to at least one of the preceding claims, **characterised in that** the welding is carried out by means of a contact welding method.

13. Method for welding a conductor to a conductive film according to at least one of the preceding claims, **characterised in that** the counter-electrode is arranged opposite the welding electrode with respect to the plane of the board.

14. Method for welding a conductor to a conductive film according to at least one of the preceding claims, **characterised in that** two welding-current-carrying electrodes are arranged between the conductive film and the thermal isolation plate on the same side with respect to the plane of the contact surface.

15. Method for welding a conductor to a conductive film according to at least one of the preceding claims, **characterised in that** two welding electrodes can be positioned with respect to the conductor.

16. Method for welding a conductor to a conductive film according to at least one of the preceding claims, **characterised in that** the counter-electrode is formed as a surface electrode and is arranged on the same side with respect to the plane of the thermal isolation plate of the welding electrode.

17. Method for welding a conductor to a conductive film according to at least one of the preceding claims, **characterised in that** the insulation on insulated conductors can be stripped off by means of thermal melting and / or by means of mechanical removal or stripping or pinching, preferably by means of thermal melting by means of a laser or by means of burning by means of the welding electrodes.

18. Method for welding a conductor to a conductive film according to at least one of the preceding claims, **characterised in that** the melting of the insulation is carried out by an electrode pair that can be positioned relative to the conductor, preferably with the control and monitoring of process parameters.

19. Method for welding a conductor to a conductive film according to at least one of the preceding claims, **characterised in that** the polarity direction of the electrode pair that can be positioned relative to the conductor is periodically changed during the stripping.

20. Method for welding a conductor to a conductive film according to at least one of the preceding claims, **characterised in that** an electrode pair that can be positioned relative to the conductor has the same polarity and is preferably connected in parallel for continuous welding.

21. Method for welding a conductor to a conductive film according to at least one of the preceding claims, **characterised in that** the conductor is tensed and held down by a pressing device at least during the welding process.

22. Method for welding a conductor to a conductive film according to at least one of the preceding claims, **characterised in that** the conductor is glued down in spots, preferably at spots at which the conductor-laying direction is changed.

23. Method for welding a conductor to a conductive film according to at least one of the preceding claims, **characterised in that** the adhesive is applied to the gluing spots preferably by means of being dropped on, jetted on or sprayed on.

24. Method for welding a conductor to a conductive film according to at least one of the preceding claims, **characterised in that** it is possible to activate the adhesive by means of applying electromagnetic energy, preferably by means of UV radiation, and / or it is possible to cross-link the adhesive and / or it is possible to accelerate the setting.

25. Device for carrying out the method according to at least one of the preceding claims, including at least the following devices that are numerically controlled by an electronic control device (32):
a) A device (8, 10, 14) for producing relative movement between a conductive film (4) and a conductor storage unit (16),
b) A device (24) for integral connection of the conductor (2) to the electrical connection points (36, 40) on the conductive film (4).
c) a thermal isolation plate for contact of the film, wherein the thermal isolation having a lower thermal conductivity than the cooper of the conductive film.
d) And a gluing device that is driven by the control device provided for gluing the conductor to the printed circuit board at points at which the conductor undergoes a change in direction.

26. Device according to Claim 25, **characterised in that** the device has a device (28) for stripping the insulation off of an insulated conductor (2).

27. Device according to at least one of the Claims 25 or 26, **characterised in that** the device has a device (30) for separating the conductor (2).

28. Device according to at least one of the Claims 25 to 27, **characterised in that** the device for producing relative movement between the conductive film (4) and the conductor storage unit (16) includes a cross table (10) that can be moved in at least two horizontal axes (X, Y) and that tenses the conductive film (4), a supporting slide (8) that can be driven relative to the cross table (10) along a vertical axis (Z), the device (28) for stripping the insulation off of the conductor (2), the device (24) for integral connection of the conductor (2) to the electrical connection points (36, 40) on the conductive film (4) and the device (30) for separating the conductor (2) and a pivot arm (14) that bears the conductor storage unit (16) and that can be driven in a pivoting manner with respect to the slide (8) by the control unit.

29. Device according to at least one of the Claims 27 to 28, **characterised in that** the conductor storage unit is formed by a conductor storage roll (16), which can be pivoted at right angles to the momentary direction in which the conductor is being laid by means of the pivot arm (14).

30. Device according to at least one of the Claims 25 to 29, **characterised in that** it furthermore includes a device (20) that can be driven by the control device, that is for producing a wire feed and that is held on the pivot arm (14).

31. Device according to at least one of the Claims 25 to 30, **characterised in that** the device has a device for tensing and / or holding down the conductor.

## Revendications

1. Procédé pour assurer le soudage d'un fil conducteur à des points de connexion électrique agencés sur un film conducteur, le film conducteur étant destiné à être relié à un substrat de plaque de circuit imprimé pour la fabrication d'une plaque de circuit imprimé, et l'épaisseur ou le diamètre du fil conducteur étant de préférence supérieur à l'épaisseur du film conducteur, **caractérisé en ce que** pendant le soudage, le film conducteur se trouve en contact avec une plaque d'isolement thermique dont la conductibilité thermique est moindre que celle du film conducteur, et **en ce que** de manière distincte de la plaque d'isolement thermique, au cours d'une étape suivante, après liaison du film conducteur à un substrat de plaque de circuit imprimé pour former une plaque de circuit imprimé, les zones prévues pour former les points de connexion sont formées par îlotage et ainsi isolées électriquement les unes des autres, par élimination partielle par gravure ou attaque du film conducteur lié au substrat de plaque de circuit imprimé.

2. Procédé pour assurer le soudage d'un fil conducteur à un film conducteur, selon la revendication 1, **caractérisé en ce que** la conductibilité thermique de la plaque d'isolement thermique est, au moins dans une région se situant autour de la zone de soudage, inférieure d'au moins un facteur 2, de préférence d'au moins un facteur 5, à celle du film conducteur.

3. Procédé pour assurer le soudage d'un fil conducteur à un film conducteur, selon la revendication 1 ou la revendication 2, **caractérisé en ce que** la plaque d'isolement thermique présente une température de fusion plus élevée et une résistance thermique plus élevée que celles du film conducteur et/ou que la sollicitation en température.

4. Procédé pour assurer le soudage d'un fil conducteur à un film conducteur, selon l'une au moins des revendications précédentes, **caractérisé en ce que** la plaque d'isolement thermique présente, au moins dans une zone de contact avec le film conducteur, située autour de la zone de soudage, de préférence dans la totalité de la zone d'appui du film conducteur, un revêtement d'une résistance thermique plus élevée et/ou d'une conductibilité thermique plus faible que le matériau de base.

5. Procédé pour assurer le soudage d'un fil conducteur à un film conducteur, selon l'une au moins des revendications précédentes, **caractérisé en ce que** la plaque d'isolement thermique présente, au moins dans une zone de contact au film conducteur, située autour de la zone de soudage, de préférence dans la totalité de la zone d'appui du film conducteur, une surface inerte, de préférence sous la forme d'un revêtement inerte.

6. Procédé pour assurer le soudage d'un fil conducteur à un film conducteur, selon l'une au moins des revendications précédentes, **caractérisé en ce que** la plaque d'isolement thermique est électriquement conductrice.

7. Procédé pour assurer le soudage d'un fil conducteur à un film conducteur, selon l'une au moins des revendications précédentes, **caractérisé en ce que** l'épaisseur de la plaque d'isolement thermique est de préférence supérieure d'au moins un facteur 5 et au plus d'un facteur 300, à celle du film conducteur.

8. Procédé pour assurer le soudage d'un fil conducteur à un film conducteur, selon l'une au moins des revendications précédentes, **caractérisé en ce que** la plaque d'isolement thermique est agencée entre le film conducteur et un dispositif de répartition de courant de préférence en un bloc de Cu.

9. Procédé pour assurer le soudage d'un fil conducteur à un film conducteur, selon l'une au moins des revendications précédentes, **caractérisé en ce que** l'épaisseur ou le diamètre du fil conducteur à souder est supérieur, de préférence d'un facteur 2 à 10, à l'épaisseur du film conducteur.

10. Procédé pour assurer le soudage d'un fil conducteur à un film conducteur, selon l'une au moins des revendications précédentes, **caractérisé en ce qu'**au point de soudage est inséré un autre composant métallique, différent du fil et/ou de la plaque.

11. Procédé pour assurer le soudage d'un fil conducteur à un film conducteur, selon l'une au moins des revendications précédentes, **caractérisé en ce que** le fil présente au moins un autre composant métallique différent du fil et/ou de la plaque, de préférence sous la forme d'un revêtement métallique, notamment en Ag ou en Sn.

12. Procédé pour assurer le soudage d'un fil conducteur à un film conducteur, selon l'une au moins des revendications précédentes, **caractérisé en ce que** le soudage est effectué par un procédé de soudage par contact.

13. Procédé pour assurer le soudage d'un fil conducteur à un film conducteur, selon l'une au moins des revendications précédentes, **caractérisé en ce que** l'électrode conjuguée est agencée à l'opposé de l'électrode de soudage en se référant au plan de la plaque.

14. Procédé pour assurer le soudage d'un fil conducteur à un film conducteur, selon l'une au moins des revendications précédentes, **caractérisé en ce que** deux électrodes conduisant le courant de soudage sont agencées sur le même côté en se référant au plan de la surface de contact entre le film conducteur et la plaque d'isolement thermique.

15. Procédé pour assurer le soudage d'un fil conducteur à un film conducteur, selon l'une au moins des revendications précédentes, **caractérisé en ce que** deux électrodes de soudage peuvent être positionnées par rapport au fil conducteur.

16. Procédé pour assurer le soudage d'un fil conducteur à un film conducteur, selon l'une au moins des revendications précédentes, **caractérisé en ce que** l'électrode conjuguée est réalisée sous forme d'électrode de surface et, en se référant au plan de la plaque d'isolement thermique, peut être agencée du même côté que l'électrode de soudage.

17. Procédé pour assurer le soudage d'un fil conducteur à un film conducteur, selon l'une au moins des revendications précédentes, **caractérisé en ce que** l'on effectue un dénudage de fils conducteurs isolés, par fusion thermique et/ou par érosion mécanique, retrait par traction ou par écrasement, de préférence par fusion thermique au moyen d'un laser ou par brûlage au moyen des électrodes de soudage.

18. Procédé pour assurer le soudage d'un fil conducteur à un film conducteur, selon l'une au moins des revendications précédentes, **caractérisé en ce que** l'on effectue la fusion de l'isolation par une paire d'électrodes pouvant être positionnées par rapport au fil conducteur, de préférence avec une commande et une surveillance de paramètres de processus.

19. Procédé pour assurer le soudage d'un fil conducteur à un film conducteur, selon l'une au moins des revendications précédentes, **caractérisé en ce que** le sens de polarisation de la paire d'électrodes pouvant être positionnées par rapport au fil conducteur, est inversé périodiquement pendant l'opération de dénudage.

20. Procédé pour assurer le soudage d'un fil conducteur à un film conducteur, selon l'une au moins des revendications précédentes, **caractérisé en ce que** les électrodes d'une paire d'électrodes pouvant être positionnées par rapport au fil conducteur, sont de même polarité et de préférence montées en parallèle pour le soudage traversant.

21. Procédé pour assurer le soudage d'un fil conducteur à un film conducteur, selon l'une au moins des revendications précédentes, **caractérisé en ce que** pendant l'opération de soudage, le fil conducteur est maintenu tendu et appliqué grâce à un dispositif presseur.

22. Procédé pour assurer le soudage d'un fil conducteur à un film conducteur, selon l'une au moins des revendications précédentes, **caractérisé en ce que** le fil conducteur est collé par endroits, de préférence au niveau des zones où la direction de pose du fil conducteur change.

23. Procédé pour assurer le soudage d'un fil conducteur à un film conducteur, selon l'une au moins des revendications précédentes, **caractérisé en ce que** l'agent de collage est appliqué sur les zones de collage, de préférence par égouttage, projection ou pulvérisation.

24. Procédé pour assurer le soudage d'un fil conducteur à un film conducteur, selon l'une au moins des revendications précédentes, **caractérisé en ce que** l'agent de collage peut être activé et/ou réticulé et/ou son adhésion peut être accélérée par l'application d'énergie électromagnétique, de préférence par rayonnement UV.

25. Installation pour la mise en oeuvre du procédé selon l'une au moins des revendications précédentes, comprenant au moins les dispositifs suivants, commandés numériquement par un appareil de commande électronique (32) :
a) un dispositif (8, 10, 14) pour produire un mouvement relatif entre un film conducteur (4) et un accumulateur de réserve de fil conducteur (16),
b) un dispositif (24) pour assurer une liaison par continuité de matière du fil conducteur (1) avec des points de connexion électrique (36, 40) sur le film conducteur (4),
c) une plaque d'isolement thermique destinée à l'appui du film, la conductibilité thermique de la plaque d'isolement thermique étant moindre que celle du cuivre du film conducteur,
d) ainsi qu'un dispositif de collage (26) pouvant être commandé par l'appareil de commande (32), et destiné à coller le fil conducteur (2) au film conducteur (4), en des zones où le fil conducteur (4) subit un changement de direction.

26. Installation selon la revendication 25, **caractérisée en ce que** l'installation comporte un dispositif (28) pour dénuder un fil conducteur (2) doté d'une isolation.

27. Installation selon l'une au moins des revendications 25 ou 26, **caractérisée en ce que** l'installation comprend un dispositif (30) pour sectionner du fil conducteur (2).

28. Installation selon l'une au moins des revendications 25 à 27, **caractérisée en ce que** le dispositif pour produire le mouvement relatif entre le film conducteur (4) et l'accumulateur de réserve de fil conducteur (16), comprend une table à mouvements croisés (10) assurant la mise en tension du film conducteur (4) et pouvant se déplacer selon au moins deux axes horizontaux (X, Y), un chariot (8) qui peut se déplacer par rapport à la table à mouvements croisés (10) le long d'un axe vertical (Z), et qui porte le dispositif (28) pour le dénudage du fil conducteur (2), le dispositif (24) pour produire la liaison par continuité de matière du fil conducteur (2) avec des points de connexion électrique (36, 40) sur le film conducteur (4), ainsi que le dispositif (30) pour le sectionnement du fil conducteur (2), et un bras pivotant (14), qui porte l'accumulateur de réserve de fil conducteur (16) et peut être entraîné en pivotement par rapport au chariot (8), à l'aide de l'appareil de commande.

29. Installation selon l'une au moins des revendications 27 à 28, **caractérisée en ce que** l'accumulateur de réserve de fil conducteur est formé par une bobine de réserve de fil conducteur (16), que l'on peut faire pivoter transversalement par rapport à la direction de pose instantanée du fil conducteur (2), au moyen du bras pivotant (14).

30. Installation selon l'une au moins des revendications 25 à 29, **caractérisée en ce qu'**elle comprend par ailleurs un dispositif (20), qui peut être commandé par l'appareil de commande pour produire une avance du fil, et est fixé au bras pivotant (14).

31. Installation selon l'une au moins des revendications 25 à 30, **caractérisée en ce que** l'installation comporte un dispositif pour tendre et/ou maintenir appliqué le fil conducteur.
